# EUROPEAN PATENT APPLICATION

(11) **EP 4 836 600 A1**
(43) Date of publication of application: **04.11.2026**
(21) Application number: 24912787.9
(22) Date of filing: 24.12.2024
(51) Int. Cl.: H05K 3/46, H01L 25/04, H01L 25/18

(54) **COMPOSITE WIRING BOARD AND SEMICONDUCTOR DEVICE**

(30) Priority: 27.12.2023 JP 2023221269
(71) Applicant: Kyocera Corporation, Kyoto-shi, Kyoto 612-8501 (JP)
(72) Inventor: ITOU, Seiichirou, Kyoto-shi, Kyoto 612-8501 (JP); GONDO, Iori, Kyoto-shi, Kyoto 612-8501 (JP); HARAZONO, Masaaki, Kirishima-shi, Kagoshima 899-4312 (JP)
(74) Representative: Viering, Jentschura & Partner mbB Patent- und Rechtsanwälte
(86) International application number: PCT/JP2024/045617
(87) International publication number: WO 2025/142900

(57) **Abstract**

A composite wiring board according to the present disclosure includes a base substrate and a relay substrate electrically connected to the base substrate via a bonding material. The base substrate includes a first core base member, a first organic base member made of an organic resin that is bonded to the first core base member, and a plurality of first wiring lines located inside the first organic base member. The relay substrate includes a second core base member, a second organic base member made of an organic resin that is bonded to the second core base member, and a plurality of second wiring lines located inside the second organic base member. A thermal expansion coefficient of the relay substrate is less than a thermal expansion coefficient of the base substrate.

## Description

### TECHNICAL FIELD

The present disclosure relates to a wiring board and a semiconductor device.

### BACKGROUND OF INVENTION

An interposer is known technology for mounting a plurality of semiconductor elements on one base substrate via a relay substrate. Patent Document 1 discloses a relay substrate made of an organic resin.

### CITATION LIST

### PATENT LITERATURE

Patent Document 1: JP 2023-083003 A

### SUMMARY

A composite wiring board according to the present disclosure includes a base substrate and a relay substrate electrically connected to the base substrate via a bonding material. The base substrate includes a first core base member, a first organic base member made of an organic resin that is bonded to the first core base member, and a plurality of first wiring lines located inside the first organic base member. The relay substrate includes a second core base member, a second organic base member made of an organic resin that is bonded to the second core base member, and a plurality of second wiring lines located inside the second organic base member. The thermal expansion coefficient of the relay substrate is less than the thermal expansion coefficient of the base substrate.

### BRIEF DESCRIPTION OF THE DRAWINGS

FIG. 1 is a schematic cross-sectional view illustrating a configuration of a semiconductor device according to an embodiment.
FIG. 2 is a schematic cross-sectional view illustrating a configuration of a base substrate according to the embodiment.
FIG. 3 is an enlarged schematic view of a region III illustrated in FIG. 2.
FIG. 4 is a schematic cross-sectional view illustrating a relay substrate according to the embodiment and the surrounding configuration.
FIG. 5 is a schematic enlarged view of a region V illustrated in FIG. 4.

### DESCRIPTION OF EMBODIMENTS

Modes (hereinafter, referred to as "embodiments") for implementing a composite wiring board and a semiconductor device according to the present disclosure are described in detail below with reference to the drawings. Note that the present disclosure is not limited by the embodiments. The respective embodiments can be appropriately combined to the extent that they do not cause inconsistencies in the processing content. In the respective embodiments below, the same portions will be denoted by the same reference signs, and repeated description thereof will be omitted.

In the following embodiments, expressions such as "certain", "orthogonal", "perpendicular", and "parallel" may be used, but these expressions need not mean exactly "certain", "orthogonal", "perpendicular", and "parallel". In other words, each of the expressions described above allows for deviations in, for example, manufacturing accuracy, or installation accuracy.

In the drawings to be referenced below, to facilitate understanding, an orthogonal coordinate system may be defined, in which the X-axis direction, Y-axis direction, and Z-axis direction mutually orthogonal are specified, and the Z-axis positive direction is set as the vertically upward direction.

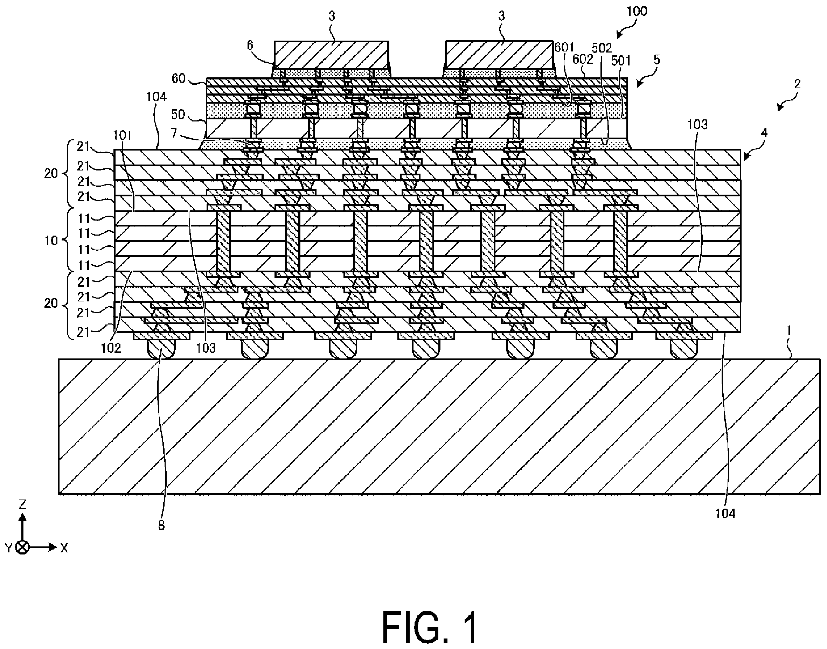

First, a configuration of a semiconductor device 100 according to an embodiment is described with reference to FIG. 1. FIG. 1 is a schematic cross-sectional view illustrating a configuration of the semiconductor device 100 according to the embodiment.

As illustrated in FIG. 1, the semiconductor device 100 includes a motherboard 1, a composite wiring board 2, and a plurality of semiconductor elements 3.

The composite wiring board 2 includes a base substrate 4 and a relay substrate 5.

The base substrate 4 is mounted over the motherboard 1. Details of the base substrate 4 are described below.

The relay substrate 5 is a so-called interposer. The relay substrate 5 relays electrical connection between the base substrate 4 and the semiconductor elements 3. The relay substrate 5 is bonded to the semiconductor elements 3 via a bonding material 6 and is bonded to the base substrate 4 via a bonding material 7.

The Young's modulus of the relay substrate 5 may be smaller than the Young's modulus of the base substrate 4. In this case, the relay substrate 5 may have flexibility that allows the relay substrate 5 to be deformed according to the shape of a surface of the base substrate 4. The bonding materials 6 and 7 are, for example, solder. Details of the relay substrate 5 are described below.

The semiconductor elements 3 are mounted over the relay substrate 5. Each of the semiconductor elements 3 is, for example, a chip or a chiplet in which a circuit or an element is formed on a substrate made of a material other than a semiconductor, such as a semiconductor chip or a glass substrate. A chiplet is a functional block constituting a part of an integrated circuit of the semiconductor device 100.

Although FIG. 1 illustrates two semiconductor elements 3, the semiconductor device 100 may include three or more semiconductor elements 3. The semiconductor device 100 may include only one semiconductor element 3. For example, when the semiconductor element 3 is a chiplet, an integrated circuit having one function may be configured by a plurality of semiconductor elements 3.

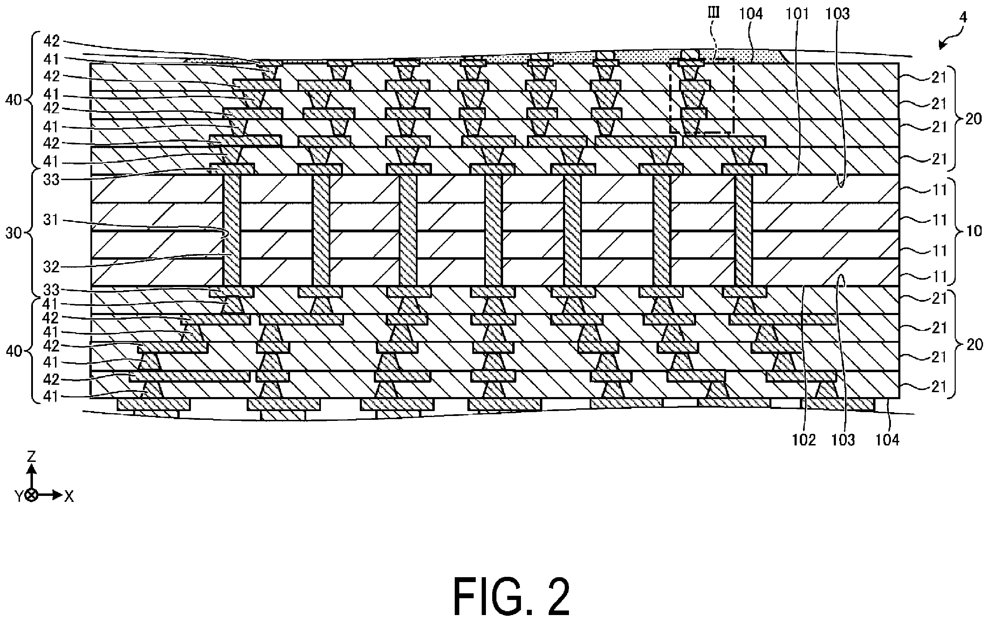

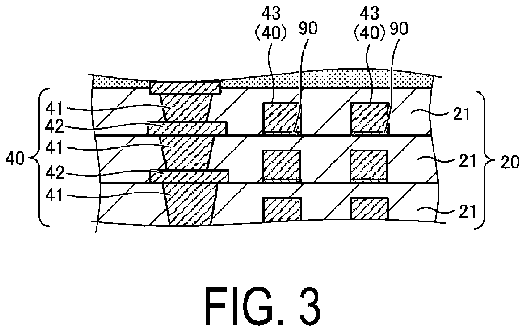

The configuration of the base substrate 4 according to the embodiment is described with reference to FIGs. 2 and 3. FIG. 2 is a schematic cross-sectional view illustrating a configuration of the base substrate 4 according to the embodiment. FIG. 3 is an enlarged schematic view of a region III illustrated in FIG. 2.

The base substrate 4 includes a first core base member 10 and a first organic base member 20. The base substrate 4 is a laminate body of the first core base member 10 and the first organic base member 20. The base substrate 4 includes a first conductor section 30 and a second conductor section 40.

### First Core Base Member

The first core base member 10 is a base member made of a ceramic. The first core base member 10 may be formed using a ceramic composite material containing a glass component, a so-called glass ceramic. The glass ceramic may be any one of a composite of a glass phase and ceramic particles, a composite of a glass phase and a crystal phase formed by crystallization of a part of the glass phase, a form in which ceramic particles are present in a glass phase, and a form in which a glass phase is present at a grain boundary between ceramic particles. The first core base member 10 formed using ceramic in this manner has a higher rigidity than a core material made of glass.

For example, the first core base member 10 may be a low temperature co-fired ceramic (LTCC). When LTCC is used as the first core base member 10, a metal having a low melting point such as copper or silver having a relatively low electric resistance can be used as the wiring line. In the present embodiment, the metal having a low melting point is a metal having a lower melting point than a general metal used for a wiring line of a ceramic base member, for example, tungsten or molybdenum.

The first core base member 10 may include a ceramic filler as the ceramic particles. As the ceramic filler, for example, alumina (aluminum oxide), calcium titanate, magnesium titanate, or the like can be used. In particular, the first core base member 10 including alumina has a high rigidity.

The first core base member 10 includes a first surface 101 and a second surface 102 on the opposite side to the first surface 101. The first core base member 10 may be a plate-shaped body having the first surface 101 and the second surface 102 as main surfaces.

In the embodiment, the first core base member 10 includes a plurality of ceramic layers 11. The plurality of ceramic layers 11 are layered along the thickness direction of the first core base member 10. The base substrate 4 including such a first core base member 10 has a high degree of freedom in design. By configuring the first core base member 10 using the plurality of ceramic layers 11, the first core base member 10 can be manufactured while checking whether the first conductor section 30 is appropriately formed for each layer, so that the yield of the first core base member 10 can be improved.

In the example illustrated in FIGs. 1 and 2, the first core base member 10 includes four ceramic layers 11; however, the number of the ceramic layers 11 is not limited to four. The number of the ceramic layers 11 may be two or three, or may be five or more.

### First Organic Base Member

The first organic base member 20 is a base member including an organic component. The organic component may be an organic resin. The organic resin may be, for example, an epoxy resin, an acrylic resin, a polycarbonate resin, a polyimide resin, an olefin resin, a polyphenylene resin, or the like.

The organic resin may be, for example, polytetrafluoroethylene (PTFE), or other fluororesin or polyphenylene ether resin. The first organic base member 20 may include a component other than the organic resin. In the present disclosure, the organic resin may be, for example, a material that accounts for 30 mass% or more of the material constituting the first organic base member 20.

The first organic base member 20 includes a third surface 103 and a fourth surface 104 on the opposite side to the third surface 103. The first organic base member 20 may be a plate-shaped body having the third surface 103 and the fourth surface 104 as main surfaces.

The base substrate 4 according to the embodiment includes two first organic base members 20. One of the two first organic base members 20 is bonded to the first surface 101 of the first core base member 10, and the other is bonded to the second surface 102 of the first core base member 10.

The first organic base member 20 located on the first surface 101 of the first core base member 10 includes the third surface 103 bonded to the first surface 101 of the first core base member 10, and the plurality of semiconductor elements 3 are mounted on the fourth surface 104 of the first organic base member 20 via the relay substrate 5 (see FIG. 1).

The first organic base member 20 located on the second surface 102 of the first core base member 10 includes the third surface 103 bonded to the first surface 101 of the first core base member 10, and the fourth surface 104 of the first organic base member 20 is bonded to the motherboard 1 via bonding portions 8 (see FIG. 1).

The first organic base member 20 includes a plurality of organic resin layers 21. The plurality of organic resin layers 21 are layered along the thickness direction of the first organic base member 20. The base substrate 4 including such a first organic base member 20 has a high degree of freedom in design. In the example illustrated in FIG. 2, the first organic base member 20 includes four organic resin layers 21; however, the number of the organic resin layers 21 is not limited to four. The number of the organic resin layers 21 may be two or three, or may be five or more.

In the example illustrated in FIGs. 1 and 2, the base substrate 4 includes the first organic base member 20 on each of the first surface 101 and the second surface 102 of the first core base member 10. The base substrate 4 is not limited thereto, and may include the first organic base member 20 on at least the first surface 101 of the first core base member 10.

The first organic base member 20 including an organic component is more likely to form a fine wiring pattern than an inorganic substrate. On the other hand, the first core base member 10 made of a ceramic has a higher rigidity than the first organic base member 20 and a lower density than the first organic base member 20.

The base substrate 4 according to the embodiment can increase the rigidity while achieving miniaturization and a narrow pitch of the wiring line by combining the first core base member 10 and the first organic base member 20. Since the warpage of the substrate is more likely to be actualized as the substrate becomes larger, the configuration of the base substrate 4 in which the low rigidity of the first organic base member 20 is compensated for by the first core base member 10 is particularly useful in increasing the size of the substrate.

The first core base member 10 and the first organic base member 20 are bonded to each other by, for example, hydrogen bonding. Specifically, the first core base member 10 and the first organic base member 20 are bonded to each other by bonding the hydroxyl groups of the first core base member 10 and the first organic base member 20 to each other. In this case, a ceramic material such as alumina having a surface hydroxyl group may be used for the first core base member 10, and an epoxy resin, which is a resin material including a hydroxyl group, may be used for the first organic base member 20. In this manner, the first core base member 10 and the first organic base member 20 are directly bonded to each other without solder, underfill, or the like interposed therebetween, so that the thickness of the base substrate 4 can be suppressed and the manufacturing process can be facilitated.

The first core base member 10 may contain a glass component, and the first organic base member 20 may contain a coupling agent chemically bonding with the glass component. As the coupling agent, for example, a silane coupling agent can be used. As the coupling agent, a titanium-based coupling agent or an aluminum-based coupling agent can also be used. According to such a configuration, the first core base member 10 and the first organic base member 20, which are different materials, can be more firmly bonded to each other by chemically bonding the first core base member 10 and the first organic base member 20.

### First Conductor Section

The first conductor section 30 is a through-hole conductor located in the first core base member 10. Specifically, the first conductor section 30 includes a through hole 31 penetrating the first core base member 10 and a conductor 32. The conductor 32 includes a metal as a main component and is located inside the through hole 31.

The first conductor section 30 includes a land 33 on the first surface 101 and the second surface 102 of the first core base member 10.

### Second Conductor Section

The second conductor section 40 includes a plurality of vias 41, a plurality of lands 42, and a plurality of first wiring lines 43. The via 41 penetrates one or more organic resin layers 21. The land 42 is located between the adjacent organic resin layers 21 and electrically connects the plurality of vias 41. The first wiring lines 43 are located inside of the first organic base member 20. The first wiring line 43 may include a diffusion prevention layer 90 on the bottom surface. The diffusion prevention layer 90 may contain any of Cr, Ti, Ni, and a compound of two or more of these elements.

The first wiring line 43 located in the first organic base member 20 bonded to the first surface 101 of the first core base member 10 and the first wiring line 43 located in the first organic base member 20 bonded to the second surface 102 are electrically connected via the conductor 32 penetrating the first core base member 10. Thus, the first wiring line 43 can be made denser.

The first conductor section 30 and the second conductor section 40 may be, for example, metal conductors including copper or silver as a main component. For example, both the first conductor section 30 and the second conductor section 40 may be metal conductors including copper as a main component. Both the first conductor section 30 and the second conductor section 40 may be metal conductors including silver as a main component. One of the first conductor section 30 and the second conductor section 40 may be a metal conductor including copper as a main component, and the other may be a metal conductor including silver as a main component.

By using a metal conductor including copper or silver as a main component for all of the first conductor section 30 and the second conductor section 40, high electrical characteristics can be obtained compared to a case where, for example, one of the first conductor section 30 and the second conductor section 40 is a metal conductor other than copper and silver.

Out of the first conductor section 30 and the second conductor section 40, only the first conductor section 30 may contain a glass component. In this case, the first conductor section 30 is firmly bonded to the first core base member 10, which also contains a glass component, via the glass component. Thus, the rigidity of the first core base member 10 can be increased.

In a firing process in the manufacture of the base substrate 4, the shrinkage rates of the first core base member 10 and the first conductor section 30 can be made uniform to some extent, which can help prevent a position shift of the first conductor section 30.

The first conductor section 30 may be formed by, for example, printing a conductor paste containing copper and a glass component on a green sheet that is a raw material of the ceramic layer 11 and simultaneously firing the conductor paste and the green sheet. Specifically, the conductor paste may contain, for example, copper powder, borosilicate glass powder, and silica particles.

On the other hand, the second conductor section 40 may be formed by copper plating. Thus, out of the first conductor section 30 and the second conductor section 40, only the first conductor section 30 may contain a glass component.

The second conductor section 40 may be electrically and thermally connected to the semiconductor element 3 via the relay substrate 5. The second conductor section 40 including copper or silver having a relatively high thermal conductivity as a main component is thermally connected to the semiconductor element 3 serving as a heat source, so that heat generated from the semiconductor element 3 can be efficiently released via the second conductor section 40 and the first conductor section 30.

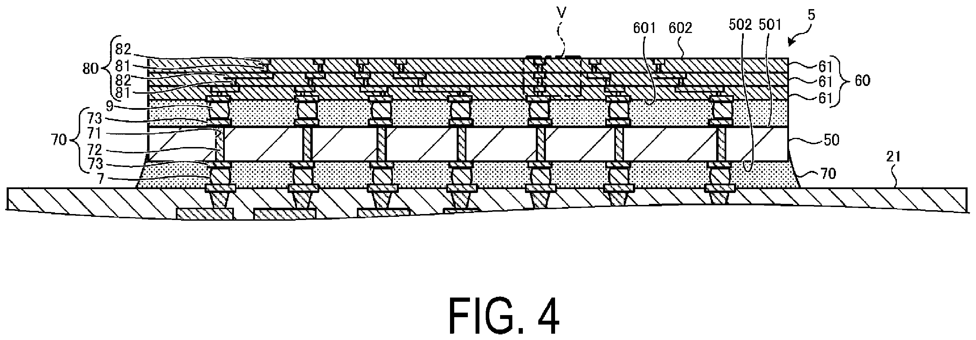

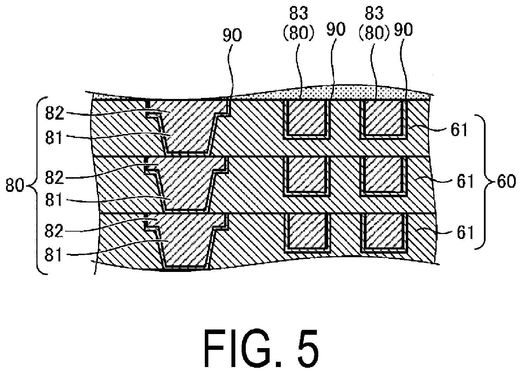

The configuration of the relay substrate 5 according to the embodiment is described with reference to FIGs. 4 and 5. FIG. 4 is a schematic cross-sectional view illustrating the relay substrate 5 according to the embodiment and the surrounding configuration. FIG. 5 is a schematic enlarged view of a region V illustrated in FIG. 4.

The relay substrate 5 includes a second core base member 50 and a second organic base member 60. The relay substrate 5 is a laminate body of the second core base member 50 and the second organic base member 60. The relay substrate 5 includes a third conductor section 70 and a fourth conductor section 80.

### Second Core Base Member

The second core base member 50 is a base member made of a ceramic. The second core base member 50 may be formed using a ceramic composite material containing a glass component, so-called glass ceramic. The glass ceramic may be any one of a composite of a glass phase and ceramic particles, a composite of a glass phase and a crystal phase formed by crystallization of a part of the glass phase, a form in which ceramic particles are present in a glass phase, and a form in which a glass phase is present at a grain boundary between ceramic particles. The second core base member 50 formed using ceramic in this manner has a higher rigidity than a core material made of glass.

For example, the second core base member 50 may be low temperature co-fired ceramics (LTCC). When LTCC is used as the second core base member 50, a metal having a low melting point such as copper or silver having a relatively low electric resistance can be used as the wiring line.

The second core base member 50 may include a ceramic filler as the ceramic particles. As the ceramic filler, for example, alumina (aluminum oxide), calcium titanate, magnesium titanate, or the like can be used. In particular, the second core base member 50 including alumina has a high rigidity.

The second core base member 50 includes a fifth surface 501 and a sixth surface 502 on the opposite side to the fifth surface 501. The second core base member 50 may be a plate-shaped body having the fifth surface 501 and the sixth surface 502 as main surfaces.

### Second Organic Base Member

The second organic base member 60 is a base member including an organic component. The organic component may be an organic resin. The organic resin may be, for example, an epoxy resin, an acrylic resin, a polycarbonate resin, a polyimide resin, an olefin resin, a polyphenylene resin, or the like.

The organic resin may be, for example, polytetrafluoroethylene (PTFE), or other fluororesin or polyphenylene ether resin. The second organic base member 60 may include a component other than the organic resin. In the present disclosure, the organic resin may be, for example, a material that accounts for 30 mass% or more of the material constituting the second organic base member 60.

The second organic base member 60 includes a seventh surface 603 and an eighth surface 604 on the opposite side to the seventh surface 603. The second organic base member 60 may be a plate-shaped body having the seventh surface 603 and the eighth surface 604 as main surfaces.

The second organic base member 60 includes the seventh surface 603 bonded to the fifth surface 501 of the second core base member 50 via a bonding material 9, and the plurality of semiconductor elements 3 are mounted on the eighth surface 604 of the second organic base member 60 via the bonding material 6 (see FIG. 1). The bonding material 9 is, for example, solder. The bonding material 9 will be described in detail below.

The second organic base member 60 includes a plurality of organic resin layers 61. The plurality of organic resin layers 61 are layered along the thickness direction of the second organic base member 60. The relay substrate 5 including such a second organic base member 60 has a high degree of freedom in design. In the example illustrated in FIG. 4, the second organic base member 60 includes three organic resin layers 61; however, the number of the organic resin layers 61 is not limited to three. The number of the organic resin layers 61 may be one or two, or may be four or more.

### Third Conductor Section

The third conductor section 70 is a through-hole conductor located in the second core base member 50. Specifically, the third conductor section 70 includes a through hole 71 penetrating the second core base member 50 and a conductor 72. The conductor 72 includes a metal as a main component and is located inside the through hole 71.

The third conductor section 70 includes a land 73 on the fifth surface 501 and the sixth surface 502 of the second core base member 50.

### Fourth Conductor Section

The fourth conductor section 80 includes a plurality of vias 81, a plurality of lands 82, and a plurality of second wiring lines 83. The via 81 penetrates one or more organic resin layers 61. The land 82 is located between the adjacent organic resin layers 61 and electrically connects the plurality of vias 81. The land 82 is formed integrally with the via 81 located in the same organic resin layer 61. The second wiring lines 83 are located inside the second organic base member 60. The second wiring line 83 may include the diffusion prevention layer 90 on the side surface and the bottom surface. Similarly, the side surface and the bottom surface of the via 81 and the side surface of the land 82 may include the diffusion prevention layer 90. Since the diffusion prevention layer 90 suppresses the diffusion of the metal component contained in the second wiring line 83 into the second organic base member 60, the diffusion prevention layer 90 can reduce the conduction between adjacent second wiring lines 83 via the metal component diffused into the second organic base member 60. That is, the insulation reliability is high.

The third conductor section 70 and the fourth conductor section 80 may be, for example, metal conductors including copper or silver as a main component. For example, both the third conductor section 70 and the fourth conductor section 80 may be metal conductors including copper as a main component. Both the third conductor section 70 and the fourth conductor section 80 may be metal conductors including silver as a main component. One of the third conductor section 70 and the fourth conductor section 80 may be a metal conductor including copper as a main component, and the other may be a metal conductor including silver as a main component.

By using a metal conductor including copper or silver as a main component for all of the third conductor section 70 and the fourth conductor section 80, high electrical characteristics can be obtained compared to a case where, for example, one of the third conductor section 70 and the fourth conductor section 80 is a metal conductor other than copper and silver.

Out of the third conductor section 70 and the fourth conductor section 80, only the first conductor section 30 may contain a glass component. In this case, the third conductor section 70 is firmly bonded to the second core base member 50, which also contains a glass component, via the glass component. Thus, the rigidity of the second core base member 50 can be increased.

In a firing process in the manufacture of the relay substrate 5, the shrinkage rates of the second core base member 50 and the third conductor section 70 can be made uniform to some extent, which can help prevent a position shift of the third conductor section 70.

The third conductor section 70 may be formed by, for example, printing a conductor paste containing copper and a glass component on a green sheet that is a raw material of the second core base member 50 and simultaneously firing the conductor paste and the green sheet. Specifically, the conductor paste may contain, for example, copper powder, borosilicate glass powder, and silica particles.

On the other hand, the fourth conductor section 80 may be formed by copper plating. Thus, out of the third conductor section 70 and the fourth conductor section 80, only the third conductor section 70 may contain a glass component.

The fourth conductor section 80 may be electrically and thermally connected to the semiconductor element 3 via the bonding material 6. The fourth conductor section 80 including copper or silver having a relatively high thermal conductivity as a main component is thermally connected to the semiconductor element 3 serving as a heat source, so that heat generated from the semiconductor element 3 can be efficiently released via the fourth conductor section 80 and the third conductor section 70.

The rigidity of the relay substrate 5 can be increased by providing the second core base material 50 in the relay substrate 5 configured as described above. Since the rigidity of the relay substrate 5 is increased, the relay substrate 5 is less likely to warp, and thus the flatness of the mounting surface of the semiconductor element 3 in the relay substrate 5 can be increased. The second wiring lines 83 included in the relay substrate 5 are made to be finer than the first wiring lines 43 included in the base substrate 4. According to the composite wiring board 2 of the embodiment, since the relay substrate 5 is less likely to warp, the electrical connection is less likely to be destabilized due to warping of the relay substrate 5. In other words, the composite wiring board 2 according to the embodiment has high electrical connection reliability.

As illustrated in FIG. 1, in the composite wiring board 2 according to the embodiment, the semiconductor elements 3 may be mounted on the relay substrate 5, and the base substrate 4 may be mounted on the motherboard 1. In this case, from the viewpoint of ensuring mounting reliability, it is desirable that the thermal expansion coefficient of the base substrate 4 is close to the thermal expansion coefficient of the motherboard 1, and the thermal expansion coefficient of the relay substrate 5 is close to the thermal expansion coefficient of the semiconductor element 3. The mounting reliability means that the electrical connection between the motherboard, the composite wiring board, and the semiconductor element is maintained even when the composite wiring board thermally expands or contracts due to a temperature change. In general, the thermal expansion coefficient of the semiconductor element is less than the thermal expansion coefficient of the motherboard. For example, the thermal expansion coefficient of the motherboard is about 40 ppm/K, whereas the thermal expansion coefficient of the semiconductor element is about 4 ppm/K. Thus, the magnitude correlation between the thermal expansion coefficients of the relay substrate and the base substrate preferably satisfies: relay substrate < base substrate. The thermal expansion coefficients of the motherboard 1, the semiconductor element 3, the base substrate 4, and the relay substrate 5 can be obtained based on the result of measurement by, for example, a thermomechanical analysis method (TMA method).

The thermal conductivity of the relay substrate 5 in the composite wiring board 2 according to the embodiment is configured to be less than that of the base substrate 4. In other words, the magnitude correlation between the thermal expansion coefficients of the relay substrate 5 and the base substrate 4 according to the embodiment satisfies: relay substrate 5 < base substrate 4. Thus, the composite wiring board 2 according to the embodiment has high mounting reliability as the composite wiring board 2 in which the base substrate 4 is mounted on the motherboard 1 and the semiconductor element 3 is mounted on the relay substrate 5.

The relay substrate 5 and the base substrate 4 having different thermal expansion coefficients can be manufactured by, for example, adjusting the ratio of the third conductor section 70 and the fourth conductor section 80 in the relay substrate 5 and the ratio of the first conductor section 30 and the second conductor section 40 in the base substrate 4 in the manufacturing process of the composite wiring board 2. As another example, when the first core base member 10 of the base substrate 4 and the second core base member 50 of the relay substrate 5 are manufactured using different materials, a difference occurs between the thermal expansion coefficient of the base substrate 4 and the thermal expansion coefficient of the relay substrate 5. In addition, when the content ratio of the inorganic material in the first organic base member 20 of the base substrate 4 and the content ratio of the inorganic material in the second organic base member 60 of the relay substrate 5 are changed, a difference occurs between the thermal expansion coefficient of the base substrate 4 and the thermal expansion coefficient of the relay substrate 5.

The magnitude correlation between the thermal expansion coefficients of the relay substrate 5 and the base substrate 4 does not necessarily have to satisfy: relay substrate 5 < base substrate 4. For example, the thermal expansion coefficient of the relay substrate 5 and the thermal expansion coefficient of the base substrate 4 may be the same, or the thermal expansion coefficient of the relay substrate 5 may be greater than the thermal expansion coefficient of the base substrate 4.

In the semiconductor device 100 in which the semiconductor element 3 is mounted on the relay substrate 5 and the base substrate 4 is mounted on the motherboard 1, the thermal expansion coefficient of the semiconductor element 3 may be equal to or less than the thermal expansion coefficient of the relay substrate 5. The thermal expansion coefficient of the relay substrate 5 may be less than the thermal expansion coefficient of the base substrate 4, and the thermal expansion coefficient of the base substrate 4 may be equal to or less than the thermal expansion coefficient of the motherboard 1. In other words, the magnitude correlation of the thermal expansion coefficients of the semiconductor element 3, the relay substrate 5, the base substrate 4, and the motherboard 1 according to the embodiment may satisfy: semiconductor element 3 < relay substrate 5 < base substrate 4 < motherboard 1. According to such a configuration, the semiconductor device 100 has high mounting reliability.

When the second core base member 50 is provided in the relay substrate 5 as described above, in the manufacturing process of the composite wiring board 2, it is conceivable that the second core base member 50 and the second organic base member 60 are first bonded to each other with the bonding material 9 to form the relay substrate 5, and then the relay substrate 5 and the base substrate 4 are bonded to each other with the bonding material 7. In this manner, when the second core base member 50 is provided on the relay substrate 5, at least two bonding processes, that is, two heat treatment processes may be required. Here, if the second core base member 50 and the second organic base member 60 are bonded using a normal bonding material such as lead-free solder or lead-containing solder, the bonding material may be melted in the first heat treatment process and then remelted in the second heat treatment process, and the connection reliability between the second core base member 50 and the second organic base member 60 may be reduced.

In view of the above, the composite wiring board 2 according to the embodiment uses the bonding material 9 with a variable melting point as the bonding material that bonds the second core base member 50 and the second organic base member 60.

The bonding material 9 with a variable melting point is a bonding material having different melting points between an initial paste state and a state after being heated to become an intermetallic compound. Specifically, the bonding material 9 with a variable melting point is melted at a first melting point of about 140°C, for example, and then the melting point when the bonding material 9 is remelted corresponds to a second melting point of about 245°C, for example, which is higher than the first melting point. The second melting point of the bonding material 9 with a variable melting point is higher than the first melting point. Specifically, the second melting point is higher than the melting point of the bonding material 7 used for bonding the relay substrate 5 and the base substrate 4. Thus, even when the composite wiring board 2 is reheated in the process of bonding the relay substrate 5 and the base substrate 4, the bonding material 9 with a variable melting point, which is the bonding material for bonding the second core base member 50 and the second organic base member 60, is not remelted. Thus, in the composite wiring board 2 according to the embodiment, the connection reliability between the second core base member 50 and the second organic base member 60 is less likely to be reduced due to the remelting of the bonding material 9.

The first melting point of the bonding material 9 with a variable melting point is lower than the melting point of the normal bonding material. Thus, when the bonding material 9 with a variable melting point is used, the difference in thermal expansion between the second core base member 50 and the second organic base member 60 in the process of bonding the second core base member 50 and the second organic base member 60 can be kept small, compared to when a normal bonding material is used. This makes it possible to make the bonding material 9 less likely to be distorted in the process described above. The difference in thermal shrinkage between the second core base member 50 and the second organic base member 60 in the subsequent cooling process is also reduced, and thus cracks are less likely to form in the bonding material 9. As described above, the composite wiring board 2 according to the embodiment has high connection reliability between the second core base member 50 and the second organic base member 60.

The bonding material 9 functions as a cushioning material. This allows the bonding material 9 to reduce the difference in thermal expansion between the second core base member 50 and the second organic base member 60.

The bonding material 7 may contain Sn and at least one selected from Ag, Bi, In, Cu, and Sb, for example.

Note that the present technique can also have the following configurations.
(1) The composite wiring board (for example, the composite wiring board 2) includes a base substrate (for example, the base substrate 4) and a relay substrate (for example, the relay substrate 5) electrically connected to the base substrate via a bonding material (for example, the bonding material 7). The base substrate includes a first core base member (for example, the first core base member 10), a first organic base member (for example, the first organic base member 20) made of an organic resin that is bonded to the first core base member, and a plurality of first wiring lines (for example, the first wiring lines 43) located inside the first organic base member. The relay substrate includes a second core base member (for example, the second core base member 50), a second organic base member (for example, the second organic base member 60) made of an organic resin that is bonded to the second core base member, and a plurality of second wiring lines (for example, the second wiring lines 83) located inside the second organic base member. The thermal expansion coefficient of the relay substrate is less than the thermal expansion coefficient of the base substrate.
(2) In the composite wiring board according to (1), the relay substrate may include a bonding material (for example, the bonding material 9) for bonding the second core base member and the second organic base member, and the bonding material may be a bonding material with a variable melting point.
(3) In the composite wiring board according to (1) or (2), the first core base member may be made of a ceramic.
(4) In the composite wiring board according to (3), the first core base member may include a plurality of ceramic layers (for example, the ceramic layers 11).
(5) The composite wiring board according to (3) or (4) may further include two first organic base members, wherein the first core base member may include a first surface (for example, the first surface 101) and a second surface (for example, the second surface 102) on the opposite side to the first surface, and the first organic base members may be bonded to the first surface and the second surface, respectively.
(6) The composite wiring board according to (5) may further include a conductor (for example, the conductor 32) penetrating the first surface and the second surface of the first core base member, wherein the first wiring line located in the first organic base member bonded to the first surface and the first wiring line located in the first organic base member bonded to the second surface may be electrically connected via the conductor.
(7) In the composite wiring board according to any one of (3) to (6), the first core base member may contain a glass component, and the first organic base member may contain a coupling agent chemically bonding with the glass component.
(8) A semiconductor device (for example, the semiconductor device 100) includes a motherboard (for example, the motherboard 1), the composite wiring board according to any one of (1) to (7) mounted on the motherboard, and a semiconductor element (for example, a semiconductor element 3) mounted on the relay substrate, wherein a thermal expansion coefficient of the semiconductor element may be equal to or less than a thermal expansion coefficient of the relay substrate, a thermal expansion coefficient of the relay substrate may be less than a thermal expansion coefficient of the base substrate, and a thermal expansion coefficient of the base substrate may be equal to or less than a thermal expansion coefficient of the motherboard.

### REFERENCE SIGNS

1 Motherboard
2 Composite wiring board
3 Semiconductor element
4 Base Substrate
5 Relay substrate
9 Bonding material
10 First core base member
20 First Organic base member
30 First conductor section
40 Second conductor section
43 First wiring line
50 Second core base member
60 Second organic base member
70 Third conductor section
80 Fourth conductor section
83 Second wiring line
100 Semiconductor device

## Claims

1. A composite wiring board, comprising:
a base substrate; and
a relay substrate electrically connected to the base substrate via a bonding material, wherein
the base substrate comprises
a first core base member,
a first organic base member made of an organic resin bonded to the first core base member, and
a plurality of first wiring lines located inside the first organic base member,
the relay substrate comprises
a second core base member,
a second organic base member made of an organic resin bonded to the second core base member, and
a plurality of second wiring lines located inside the second organic base member, and
a thermal expansion coefficient of the relay substrate is less than a thermal expansion coefficient of the base substrate.

2. The composite wiring board according to claim 1, wherein
the relay substrate comprises a bonding material bonding the second core base member and the second organic base member, and
the bonding material is a bonding material with a variable melting point.

3. The composite wiring board according to claim 1 or 2, wherein
the first core base member is made of a ceramic.

4. The composite wiring board according to claim 3,
wherein
the first core base member comprises a plurality of ceramic layers.

5. The composite wiring board according to claim 3 or 4, further comprising:
two first organic base members, wherein
the first core base member comprises
a first surface, and
a second surface on an opposite side to the first surface, and
the first organic base members are bonded to the first surface and the second surface, respectively.

6. The composite wiring board according to claim 5, further comprising:
a conductor penetrating the first surface and the second surface of the first core base member, wherein
the first wiring line located in the first organic base member bonded to the first surface and the first wiring line located in the first organic base member bonded to the second surface are electrically connected via the conductor.

7. The composite wiring board according to any one of claims 3 to 6, wherein
the first core base member contains a glass component, and
the first organic base member contains a coupling agent chemically bonding with the glass component.

8. A semiconductor device, comprising:
a motherboard;
the composite wiring board according to any one of claims 1 to 7 mounted on the motherboard; and
a semiconductor element mounted on the relay substrate,
wherein a thermal expansion coefficient of the semiconductor element is equal to or less than a thermal expansion coefficient of the relay substrate, a thermal expansion coefficient of the relay substrate is less than a thermal expansion coefficient of the base substrate, and a thermal expansion coefficient of the base substrate is equal to or less than a thermal expansion coefficient of the motherboard.
